**Europäisches Patentamt**

**European Patent Office**

**Office européen des brevets**

(19)

(11) Numéro de publication : **0 364 521 B1**

# FASCICULE DE BREVET EUROPEEN

(12)

(45) Date de publication du fascicule du brevet :
**11.11.92 Bulletin 92/46**

(51) Int. Cl.$^5$ : **F16B 5/07, A44B 18/00**

(21) Numéro de dépôt : **89902795.7**

(22) Date de dépôt : **21.02.89**

(86) Numéro de dépôt international :
**PCT/FR89/00066**

(87) Numéro de publication internationale :
**WO 89/08201 08.09.89 Gazette 89/21**

(54) **SYSTEME D'ASSEMBLAGE PAR ACCROCHAGE COMPORTANT DES ELEMENTS D'ACCROCHAGE FORMES PAR DES NERVURES POURVUES DE LEVRES ELASTIQUEMENT DEFORMABLES, EN PARTICULIER CURVILIGNES.**

(30) Priorité : **26.02.88 FR 8802389**
**22.09.88 FR 8812399**

(43) Date de publication de la demande :
**25.04.90 Bulletin 90/17**

(45) Mention de la délivrance du brevet :
**11.11.92 Bulletin 92/46**

(84) Etats contractants désignés :
**AT BE CH DE GB IT LI LU NL SE**

(56) Documents cités :
**DE-A- 1 784 067**
**DE-A- 2 504 863**
**US-A- 3 192 589**

(73) Titulaire : **Berger, Michel**
**104 La Lande Sainte Hélène**
**F-33 480 Castelnau de Médoc (FR)**
Titulaire : **DE POURTALES, Hélie**
**40 rue du Bac**
**F-75007 Paris (FR)**

Titulaire : **PERRODO, Hubert**
**6, rue des Marronniers**
**F-75016 Paris (FR)**
Titulaire : **DE NOAILLES, Hélie**
**4, rue deTournon**
**F-75006 Paris (FR)**

(72) Inventeur : **Berger, Michel**
**104 La Lande Sainte Hélène**
**F-33 480 Castelnau de Médoc (FR)**
Inventeur : **DE POURTALES, Hélie**
**40 rue du Bac**
**F-75007 Paris (FR)**
Inventeur : **PERRODO, Hubert**
**6, rue des Marronniers**
**F-75016 Paris (FR)**
Inventeur : **DE NOAILLES, Hélie**
**4, rue deTournon**
**F-75006 Paris (FR)**

(74) Mandataire : **Portal, Gérard et al**
**Cabinet Beau de Loménie 55, rue d'Amsterdam**
**F-75008 Paris (FR)**

EP 0 364 521 B1

# Description

La présente invention concerne essentiellement un système d'assemblage par accrochage comportant des éléments d'accrochage formés par des nervures pourvues de lèvres élastiquement déformables, en particulier curvilignes.

Des systèmes d'assemblage par accrochage, notamment pour fermeture par accrochage, sont notoirement connus. Le plus connu d'entre eux est le système d'accrochage dit "Velcro".

A titre d'exemples de tels dispositifs, on peut citer le document FR-A-2 101 195. On y décrit un système d'assemblage par accrochage comprenant un premier dispositif d'assemblage (1) habituellement en forme de bande (3), pourvu sur une face dite d'accrochage d'une pluralité de premiers éléments d'accrochage (5, 6) au moins en partie élastiquement déformables, et un deuxième dispositif d'assemblage également habituellement en forme de bande (3), pourvu sur une face dite d'accrochage d'une pluralité de seconds éléments d'accrochage (5, 6) au moins en partie élastiquement déformables permettant, lors d'un rapprochement relatif desdits premier et second dispositifs avec leurs éléments d'accrochage (5, 6) en face les uns des autres, l'accrochage des seconds éléments d'accrochage avec les premiers éléments d'accrochage par déformation élastique des premier et second moyens d'accrochage. Dans ce document, les premiers éléments d'accrochage (5, 6) et les seconds éléments d'accrochage sont de forme identique, en procurant ainsi une symétrie complète des premier et second dispositifs d'assemblage.

Dans ce document, comme dans tous les dispositifs d'assemblage du type dit "Velcro", au moins les éléments d'accrochage de l'un des deux dispositifs d'assemblage sont constitués par des éléments mâles de type filiforme obtenus par découpage de boucles fermées (2, 4) (figure 3) ou (22 à 25) (figure 4) de FR-A-2 101 195.

Le procédé de fabrication de telles bandes ou rubans pour dispositif de fermeture par accrochage est donc compliqué, et fort coûteux.

Des perfectionnements ont été apportés à de tels dispositifs, décrits dans les documents FR-A-2 196 131 ; FR-A-2 435 221 ; FR-A-2 450 282 ; EP-A-0 037 652 ou EP-A-0 250 175.

Ces perfectionnements vont tous dans le sens d'une complication du procédé de fabrication par l'emploi d'éléments filiformes coudés en U, noyés dans la masse d'un support qui est réalisé multicouches.

En outre, de tels dispositifs résistent mal au vieillissement et perdent une grande partie de leurs performances quant à leur résistance à l'arrachement, au cours du temps, ce qui est préjudiciable.

Par ailleurs, dans la technique des fermetures à glissières, on connaît par DE-A-22 23 943 et son Certificat d'Addition DE-A-25 04 863, des éléments d'accrochage rigides à profil en T, dont les éléments s'interpénétrent grâce à la souplesse d'une bande de support supportant les éléments d'accrochage rigides. Ce système a été abandonné car la technique. des fermetures à glissières n'est pas utilisable dans le cadre des systèmes d'assemblage par accrochage de deux bandes mises en regard l'une de l'autre. Egalement, dans ces documents, il est nécessaire, pour éviter un glissement latéral, d'utiliser un fil (7) de fixation chevauchant une pièce intermédiaire (5) disposée entre les têtes d'accouplement (4, 4'). Le Certificat d'Addition couvre l'emploi supplémentaire d'une bande textile (3) incorporée dans la bande support (2, 2') souple.

La présente invention a donc pour but de remédier aux inconvénients précités.

Ainsi, la présente invention a pour but de résoudre le nouveau problème technique consistant en la fourniture d'un système d'assemblage par accrochage qui soit extrêmement simple pour pouvoir être fabriqué selon un procédé de fabrication peu coûteux.

La présente invention a encore pour but de résoudre le nouveau problème technique consistant en la fourniture d'un système d'assemblage par accrochage dont les éléments d'accrochage ne sont pas sujets à un effet de vieillissement mais conservent au contraire leurs performances initiales au cours du temps, et notamment après plusieurs assemblages et désassemblages.

La présente invention a encore pour but de résoudre le nouveau problème technique consistant en la fourniture d'un système d'assemblage par accrochage qui présente une résistance au désaccrochage, c'est-à-dire à la séparation des dispositifs d'assemblage, bien supérieure à la résistance au désassemblage des systèmes d'assemblage par accrochage antérieurement connus.

La présente iinvention a encore pour but de résoudre le nouveau problème technique consistant en la fourniture d'un système d'assemblage par accrochage qui puisse être fabriqué par un procédé par extrusion.

Tous ces nouveaux problèmes techniques sont résolus pour la première fois par la présente invention d'une manière extrêmement simple, à un coût extrêmement réduit, permettant une utilisation à l'échelle industrielle dans une multiplicité de domaines techniques, que ce soit pour la réalisation de fermetures, notamment du type "Eclair" ou "Velcro", pour la réalisation de système d'accrochage suspendu auquel on peut suspendre des objets présentant un certain poids, ainsi que dans le domaine aéronautique.

Ainsi, selon la présente invention, on fournit un système d'assemblage par accrochage, notamment pour fermeture par accrochage, comprenant un premier dispositif d'assemblage habituellement en forme de bande, pourvu sur une face dite d'accrochage d'une pluralité de premiers éléments d'accrochage au moins en partie élastiquement déformables, et un deuxième dispositif d'assemblage également habituellement en forme de bande, pourvu sur une face dite d'accrochage d'une pluralité de seconds éléments d'accrochage au moins en partie élastiquement déformables, permettant, lors d'un rapprochement relatif desdits premier et second dispositifs d'assemblage avec leurs éléments d'accrochage en regard les uns des autres, l'accrochage des seconds éléments d'accrochage avec les premiers éléments d'accrochage par déformation élastique des premier et second éléments d'accrochage, caractérisé en ce que les premiers éléments d'accrochage et les seconds éléments d'accrochage sont formés par des nervures pourvues de lèvres élastiquement déformables faisant saillie de part et d'autre de la nervure pour définir entre les lèvres de deux nervures successives des étranglements entre les nervures de dimension inférieure à l'empattement des lèvres d'une nervure donnée.

Avantageusement, ces nervures sont discontinues et sont disposées soit en alignement, soit décalées ou en quinconce.

Dans le cas où les nervures sont discontinues, les nervures sont séparées par des saignées dont la dimension est inférieure à la longueur de la nervure.

Selon une variante, les premiers éléments d'accrochage et les seconds éléments d'accrochage étant de forme identique, procurent une symétrie complète du premier dispositif d'assemblage et du second dispositif d'assemblage.

Selon un mode de réalisation particulier, les nervures sont disposées transversalement par rapport à la bande formant chaque dispositif d'assemblage.

Ces nervures sont avantageusement disposées sensiblement parallèlement entre elles et sensiblement perpendiculairement au dispositif d'accrochage sur lequel elles sont formées.

Selon une première variante de réalisation, les nervures avec leurs lèvres ont en section droite un profil en T, l'angle des bras du T avec la jambe du T pouvant varier dans de larges limites en étant au plus environ égal à 90°. L'angle de 90° constitue un mode de réalisation avantageux, ainsi qu'un angle inférieur de 60 ou 45°, environ.

Selon une autre variante de réalisation, les nervures avec leurs lèvres ont en section droite un profil en champignon.

Ces dispositifs d'assemblage selon l'invention avec leurs éléments d'accrochage sous forme de nervures pourvues de lèvres peuvent être réalisés en tout matériau, et notamment en matériau composite. Des exemples de matériaux composites appropriés sont ceux décrits dans la demande antérieure FR-A-2592404, qui décrit des matériaux composites armés de fibres orientées tridimensionnellement. Ces fibres tissées en trois dimensions peuvent être choisies en particulier parmi le carbure de silicium, un mélange de carbure de silicium et de titane, en bore, en carbone, tandis que la matrice peut être avantageusement réalisée en carbure de silicium, en graphite, ou encore en carbone ou même en oxyde de zirconium. On peut également utiliser des matériaux composites comprenant des fibres tissées en deux dimensions, ces fibres étant choisies en particulier parmi le groupe consistant de carbure de silicium, de zircone, d'alumine ou de mélanges d'oxyde d'aluminium et d'oxyde de silicium. La matrice dans laquelle sont baignées ces fibres est avantageusement choisie parmi le groupe consistant de zircone, d'alumine, ou encore de mélanges d'oxyde d'aluminium et de silicium. Dans ce cas de fibres orientées bidimensionnellement, on peut préparer le matériau composite selon le procédé décrit dans la demande antérieure FR-A-2570646, équivalente à US-A-4 707 231.

Un tel système d'assemblage par accrochage selon l'invention peut être préparé d'une manière extrêmement simple, peu coûteuse par un procédé par extrusion.

Un autre procédé de fabrication également très peu coûteux de chaque dispositif d'assemblage pour former le système d'assemblage, est caractérisé en ce qu'on réalise des plis sensiblement parallèles dans deux bandes à l'aide de deux moyens de plissage appropriés, on dispose ces deux bandes à une distance prédéterminée l'une de l'autre avec les plis respectifs en regard, mais décalés, on rapproche les deux bandes jusqu'à ce que les bords des plis d'une bande soient en contact avec l'autre bande, on solidarise les bords des plis avec la bande avec laquelle ils sont en contact, et on réalise des découpes entre les plis de l'une des deux bandes.

Selon une variante de réalisation de ce procédé, on solidarise une autre bande formant support sur la bande opposée à celle comportant les découpes ou destinée à porter les découpes, par exemple un tissé.

Selon un mode de réalisation particulier, les plis comprennent des tronçons successifs dont au moins certains sont décalés d'un demi-pas.

Selon un autre mode de réalisation avantageux du procédé selon l'invention, les bandes sont des bandes continues, de sorte que le procédé est réalisé en continu par déroulage continu de chaque bande qui peuvent être ensuite découpées à la longueur voulue.

Ces bandes peuvent être réalisées en tout matériau, notamment en matière plastique, ce qui permet un pliage à chaud, ou en matière composite.

On obtient ainsi tous les avantages techniques déterminants précédemment énoncés. Un tel système d'assemblage selon l'invention peut être fabriqué avec un coût extrêmement faible, avec une extrême facilité, en tout matériau, de telle sorte que les utilisations possibles de ce système d'assemblage sont pratiquement illimitées. On peut citer en particulier des utilisations pour réaliser des fermetures, notamment du type "Eclair" ou "Velcro", pour réaliser des systèmes d'accrochage suspendus auxquels divers objets même présentant un certain poids peuvent être accrochés, grâce à leur extrême résistance à l'arrachement.

On a vu que dans les modes de réalisation précédents les nervures, avec leurs lèvres, ont, en section droite, un profil en T. Les nervures sont rectilignes et peuvent être continues ou discontinues. Pour éviter un glissement longitudinal des deux dispositifs d'assemblage en position assemblée, il a été proposé, notamment en référence à la figure 6, de réaliser des nervures 214a, 214b décalées d'un demi-pas.

La présente invention a encore pour but d'apporter divers perfectionnements au système d'assemblage par accrochage décrits ci-dessus, permettant d'éviter un glissement longitudinal des deux dispositifs d'assemblage en position assemblée, grâce à une solution extrêmement simple.

La présente invention a donc pour but de résoudre le nouveau problème technique consistant en la fourniture d'un système d'assemblage par accrochage du type décrit précédemment évitant un glissement longitudinal, tout en étant d'une conception particulièrement simple.

Ce nouveau problème technique est résolu pour la première fois par la présente invention d'une manière satisfaisante, utilisable à l'échelle industrielle.

Ainsi, selon un premier aspect, la présente invention fournit un système d'assemblage par accrochage du type décrit précédemment, caractérisé en ce que les nervures ont un profil curviligne. En outre, les dispositifs d'assemblage peuvent être soit de structure différente soit identiques, notamment pour faciliter l'accrochage.

Selon un mode de réalisation particulier, les nervures ont un profil en arc de cercle, ces nervures étant ainsi concentriques entre elles.

Selon un autre mode de réalisation de l'invention, les nervures ont un profil sinusoïdal.

Naturellement, selon une variante, les nervures peuvent être discontinues, et, dans ce cas, elles sont de préférence alignées et séparées par des saignées dont la dimension est inférieure a la longueur des nervures.

Selon un autre mode de réalisation de l'invention, les nervures sont continues.

Les nervures avec leurs lèvres ont, en section droite, un profil en T, les lèvres formant avec les nervures un angle au plus égal à 90° environ.

Selon une autre caractéristique particulièrement avantageuse de l'invention, les nervures avec leurs lèvres sont réalisées en un matériau choisi parmi le groupe consistant d'un métal, d'une matière plastique, d'un matériau composite ou d'une matière élastomère ou encore tout matériau extrudable ou moulable.

Selon un deuxième aspect, la présente invention fournit aussi un procédé de fabrication d'un dispositif d'assemblage pour système d'assemblage, caractérisé en ce qu'on extrude deux bandes en matériau extrudable avec des nervures à profil curviligne.

Selon un mode de réalisation avantageux, on extrude deux bandes en matériau extrudable avec des nervures à profil sinusoïdal, grâce à l'emploi de deux filières d'extrusion comprenant une filière fixe d'extrusion et une filière mobile animée d'un déplacement alternatif dans le sens perpendiculaire au défilement de la bande pendant que le matériau extrudable est encore mou.

On constate ainsi que, grâce à l'invention, on évite tout glissement longitudinal des deux dispositifs d'assemblage en position assemblée, grâce à une réalisation particulièrement simple, peu coûteuse.

Selon encore un perfectionnement au système d'assemblage précité, le rapport en pourcentage de l'épaisseur des lèvres à l'épaisseur des nervures est compris entre 20-30 et 70-80, de préférence entre 20-30 et 60-70.

Selon une autre variante de réalisation également avantageuse, le profil général des lèvres d'une nervure donnée est incurvé en direction de la nervure, en procurant ainsi un profil dit en champignon.

Selon encore une autre caractéristique avantageuse de l'invention, l'extrémité des lèvres précitées comprend un bec recourbé vers la nervure ou une surépaisseur interne servant de point de résistance contre un désassemblage.

D'autres buts, caractéristiques et avantages de l'invention apparaîtront clairement à la lumière de la description explicative qui va suivre, faite en référence aux dessins annexés représentant plusieurs modes de réalisation actuellement préférés de l'invention donnés simplement à titre d'illustration et qui ne sauraient donc en aucune façon limiter la portée de l'invention.

Dans les dessins :
- la figure 1 représente en perspective, en coupe partielle, un dispositif d'assemblage selon l'invention pour système d'assemblage par accrochage ;
- la figure 2 représente une vue de côté, en élévation, en coupe partielle d'un deuxième mode de réalisation d'un système d'assemblage selon l'invention en position assemblée ;
- la figure 3 représente un troisième mode de réalisation selon une vue similaire à celle de la figure 2, d'un système d'assemblage selon l'invention, en position assemblée ;
- les figures 4a à 4d représentent le procédé d'assemblage et de désassemblage du système d'assemblage selon l'invention ; la figure 4a représentant chacun des deux dispositifs d'assemblage selon l'invention conformes au mode de réalisation de la figure 1, en position avant assemblage ; la figure 4b représente la position intermédiaire au moment de l'accrochage ; la figure 4c représente la position assemblée ; et la figure 4d représente le système d'assemblage en position partiellement désassemblée, certains éléments d'accrochage étant décrochés ou désassemblés ;

- les figures 5a à 5d représentent un procédé de fabrication selon l'invention qui sera décrit en détail plus loin ; et

- la figure 6 représente un quatrième mode de réalisation d'un dispositif d'assemblage selon l'invention.

- la figure 7 représente une vue en coupe schématique, selon la ligne de coupe VII-VII de la figure 8, d'un cinquième mode de réalisation d'un système d'assemblage selon la présente invention ;

- la figure 8 représente une vue en coupe selon la ligne de trace VIII-VIII de la figure 7 ;

- la figure 9 représente une vue en coupe partielle selon la ligne de trace IX-IX de la figure 10, constituée elle-même d'une coupe partielle d'un sixième mode de réalisation d'un système d'assemblage selon la présente invention ; et

- la figure 10 représente une vue en coupe selon la ligne de trace X-X de la figure 9 ;

- la figure 11 représente encore un mode de réalisation de l'invention selon une vue en coupe schématique similaire à celle des figures 2, 3, 4a à d, permettant de voir clairement que les extrémités des lèvres présentent un bord recourbé ou une surépaisseur, avant assemblage ;

- la figure 12 représente une vue similaire à la figure 11 après assemblage ;

- la figure 13 représente une variante de réalisation d'un système d'assemblage selon l'invention également avec des lèvres présentant à leur extrémité un bord recourbé ou une surépaisseur, avant assemblage comme dans le cas de la figure 11 ;

- la figure 14 représente une vue similaire à la figure 13 mais après assemblage.

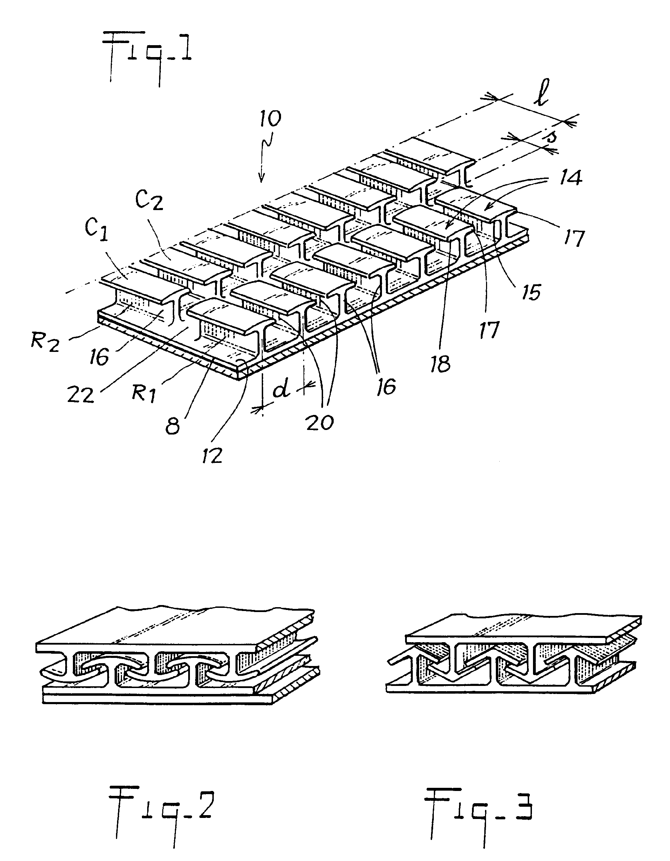

En référence à la figure 1, selon un premier mode de réalisation d'un système d'assemblage selon l'invention, celui-ci est formé par deux dispositifs d'assemblage identiques représentés par le numéro de référence général 10. Chaque dispositif d'assemblage 10 est habituellement en forme de bande, et est pourvu sur une face 12 dite d'accrochage d'une pluralité d'éléments d'accrochage 14, au moins en partie élastiquement déformables. Selon l'invention, les éléments d'accrochage 14 sont formés par des nervures 16 pourvues de lèvres 17, 18 élastiquement déformables, formant saillie de part et d'autre de la nervure 16 pour définir entre les lèvres 17, 18 des étranglements 20 (et entre les nervures 16), de dimension inférieure à l'empattement des lèvres 17, 18 d'une nervure donnée.

Selon un mode de réalisation particulier, tel que représenté à la figure 1, les nervures 16 sont discontinues. Elles peuvent être également en particulier alignées, comme représenté à la figure 1. Ces nervures discontinues alignées sont donc en quelque sorte disposées en rangées $R_1$, $R_2$, etc. et en colonnes $C_1$, $C_2$, etc.

Des nervures d'une même colonne, par exemple $C_1$, qui sont ici discontinues, sont séparées par des saignées 22 qui déterminent ainsi des longueurs l de chaque nervure individuelle, l'ensemble des rangées de nervure déterminant la longueur du dispositif d'assemblage en forme de bande. La dimension de ces saignées est avantageusement inférieure à la longueur l d'une nervure individuelle de manière à éviter un désassemblage accidentel. La présence de ces saignées 22 est bénéfique car l'expérience montre qu'il n'y a pas de glissement longitudinal malgré l'alignement des nervures discontinues 16. Il est à noter que la dimension des saignées 22 peut être réalisée selon un pas régulier, ou selon un pas irrégulier.

Par ailleurs, la distance entre les nervures 16 de colonnes successives, référencée d, peut varier dans de larges limites qui dépendent de la dimension des lèvres 17, 18. Cependant, il est bien clair que pour améliorer les performances de résistance au désassemblage, la dimension totale des nervures 17, 18 ne doit pas être trop grande par rapport à la dimension de la nervure. Il est préféré que la surface totale des lèvres 17, 18 soit voisine de la surface de la nervure.

Selon un mode de réalisation particulier, ces nervures 16 sont disposées dans le sens longitudinal par rapport au dispositif d'accrochage en forme de bande 10, surtout lorsque ces nervures sont discontinues. Ces nervures peuvent être aussi bien disposées dans le sens transversal, ce qui sera en pratique le cas lorsque les nervures sont continues.

Selon un mode de réalisation particulier, les nervures 16 avec leurs lèvres 17, 18 ont en section droite un profil en T, comme représenté à la figure 1. Les lèvres du T peuvent former un angle variable par rapport à la jambe du T définie par la nervure elle-même 16. Dans cet exemple, les lèvres 17, 18 forment un angle de 90° par rapport aux nervures 16. Ainsi, lorsque les nervures sont disposées verticalement, les lèvres sont disposées sensiblement horizontalement.

On peut prévoir que chaque dispositif d'assemblage 10 comprenne une couche support S qui est solidarisée de la couche 8 sur la face 12 de laquelle sont définies les nervures 16.

La couche support S peut être réalisée en un matériau différent de la couche 8. En outre, les nervures elles-mêmes ainsi que les lèvres peuvent être réalisées en des matériaux différents, ce qui est extrêmement aisé à réaliser dans le cas d'une fabrication du dispositif d'assemblage 10 par extrusion.

On comprend ainsi que ces éléments d'accrochage 14 peuvent être réalisés en tout matériau, qu'il s'agisse d'une matière plastique, d'un métal, d'un matériau composite et en particulier d'un matériau composite tel que ceux décrits dans les demandes antérieures précédemment citées FR-A-2592404 et FR-A-2570646 ou US-4 707 231.

A la figure 2, on a représenté une variante de réalisation des lèvres, de telle sorte que l'ensemble des nervures avec les lèvres présente un profil en champignon en ayant les lèvres incurvées pour définir des tronçons de cylindre dont la concavité est tournée vers la nervure. On peut encore considérer ici que les lèvres forment un angle inférieur à 90° par rapport aux nervures.

En référence à la figure 3, on a représenté une autre variante de réalisation des lèvres qui sont sensiblement planes et qui sont disposées selon un angle voisin de 45° par rapport aux nervures. Les positions assemblées des figures 2 et 3 permettent d'observer clairement le fonctionnement des éléments d'accrochage. La résistance au désassemblage est augmentée par le fait que les lèvres forment un angle inférieur à 90° par rapport aux nervures, comme cela est bien compréhensible à l'homme de l'art.

En référence aux figures 4a à 4d, on a représenté le procédé d'assemblage et de désassemblage de deux dispositifs d'assemblage identiques selon l'invention. Il s'agit par exemple du dispositif d'assemblage représenté à la figure 1.

On peut observer qu'un premier dispositif d'assemblage A est disposé en regard d'un second dispositif d'assemblage B, de telle sorte que les nervures soient décalées, de préférence selon un demi-pas, c'est-à-dire d'une distance d/2.

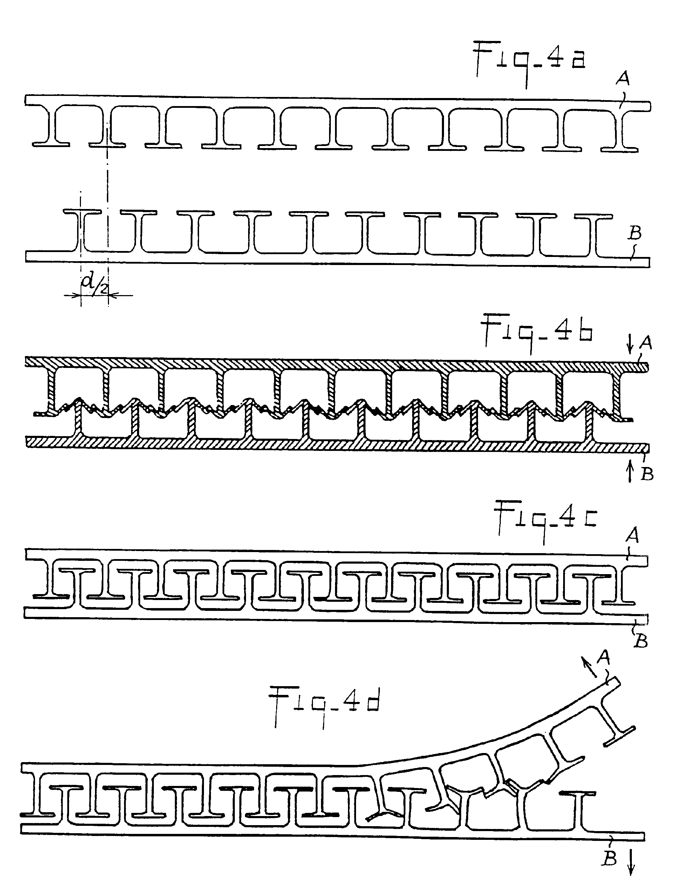

On approche les dispositifs A et B de telle sorte que les lèvres respectives viennent en contact comme représenté à la figure 4b. On continue le rapprochement de manière à faire pénétrer à force les lèvres entre les nervures comme représenté à la figure 4c. On obtient ainsi le système d'assemblage à l'état assemblé de la figure 4c. Pour réaliser un décrochage ou désassemblage, il suffit d'exercer des efforts dans le sens des flèches, d'une valeur supérieure à la valeur qui est nécessaire pour désengager les lèvres respectives par déformation élastique de celles-ci comme représenté à la figure 4d.

On comprend naturellement que la résistance à la déformation élastique des lèvres constitue un facteur important pour déterminer 'la résistance au désassemblage et donc la sécurité d'assemblage. Les lèvres doivent donc être suffisamment élastiques pour permettre un assemblage ou accrochage à force comme cela ressort clairement de la figure 4b tout en étant suffisamment rigides pour aboutir à une résistance au désassemblage ou décrochage de l'ensemble du système d'assemblage suffisamment élevée.

Ceci est obtenu sans problème avec n'importe quel matériau qui présente une capacité de déformation élastique. Ces matériaux peuvent être choisis parmi des métaux, parmi les matériaux plastiques ou parmi les matériaux composites ou des tissés.

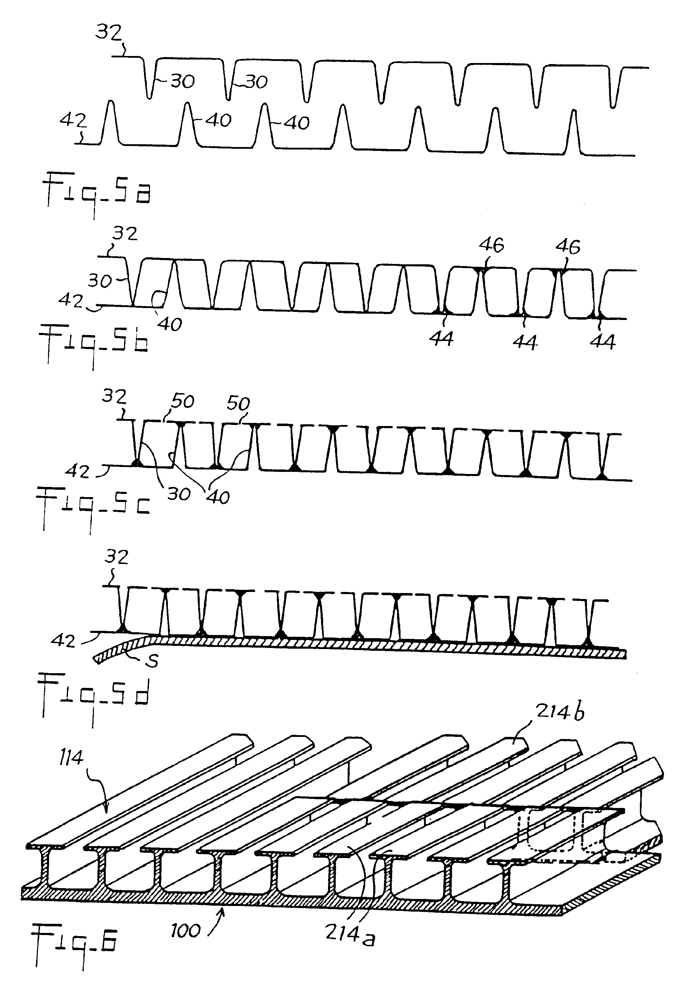

En référence aux figures 5a à 5d, on a représenté un procédé de fabrication particulier, par exemple du dispositif d'assemblage représenté à la figure 1.

Ce procédé de fabrication comprend les étapes suivantes :

a) on réalise des plis 30, 40, sensiblement parallèles, dans deux bandes 32, 42, à l'aide de tout moyen de plissage ou pliage approprié, tel que des rouleaux comportant des nervures dont la hauteur est fonction de la profondeur recherchée du pli 30 ou 40.

Les bandes plissées sont représentées à la figure 5a.

Un tel plissage peut être très aisément réalisé à chaud lorsque les bandes 32, 42 sont réalisées en matériau plastique thermoformable.

b) on dispose ces deux bandes 32, 42 à une distance prédéterminée l'une de l'autre avec les plis respectifs en regard, mais décalés, ce qui est encore représenté à la figure 5a.

c) on rapproche les deux bandes 32, 42 jusqu'à ce que les bords des plis 30, 40 soient en contact avec l'autre bande comme représenté à la figure 5b.

d) on solidarise les bords, ou les sommets, des plis 30, 40 avec la bande 32 ou 42 avec laquelle ils sont en contact par tout moyen approprié, tel que soudure ou collage, les points de solidarisation étant référencés par exemple 44 sur la bande 42 et 46 sur la bande 32, comme encore représenté à la figure 5b.

e) enfin, on réalise des découpes 50 entre les plis 30, 40, sur une seule des deux bandes. Ces découpes sont donc réalisées selon un pas qui est le quart du pas des plissages initiaux 30 ou 40 et de manière à se trouver toujours entre des plis 30 et 40. On constate que les plis 30 sont creux. Ils peuvent être obturés par un matériau quelconque et notamment un matériau de même nature que le matériau constituant la bande initiale 32.

Selon une variante de réalisation, on peut solidariser une autre bande formant support S sur la bande 42 opposée à la bande 32 comportant les découpes ou destinée à comporter les découpes 50, comme représenté à la figure 5d, par exemple un tissé.

Selon ce procédé de fabrication, on obtient une fabrication extrêmement aisée des dispositifs d'assemblage, avec un coût extrêmement faible. Ce procédé de fabrication peut être réalisé en continu sans aucun problème à une cadence très élevée, d'une manière totalement automatisée.

En référence à la figure 6, on a représenté un autre mode de réalisation des éléments d'accrochage selon l'invention référencés ici 114. Selon une première variante représentée à la partie gauche de la figure 6, les éléments d'accrochage 114 sont réalisés sous forme de nervures continues disposées transversalement au dispositif d'accrochage 100. A la partie droite de la figure 6, on a représenté une variante de réalisation selon laquelle les nervures 214a, 214b sont discontinues tout en étant disposées bord à bord mais décalées. En particulier, selon le mode de réalisation particulièrement avantageux représenté à la partie droite de la figure 6, les nervures 214b sont décalées d'un demi-pas par rapport aux nervures 214a, ou encore sont disposées en quinconce. Cette disposition est très avantageuse pour empêcher que, après assemblage de deux dispositifs d'assemblage 100 identiques, il puisse se produire un glissement dans le sens longitudinal des nervures.

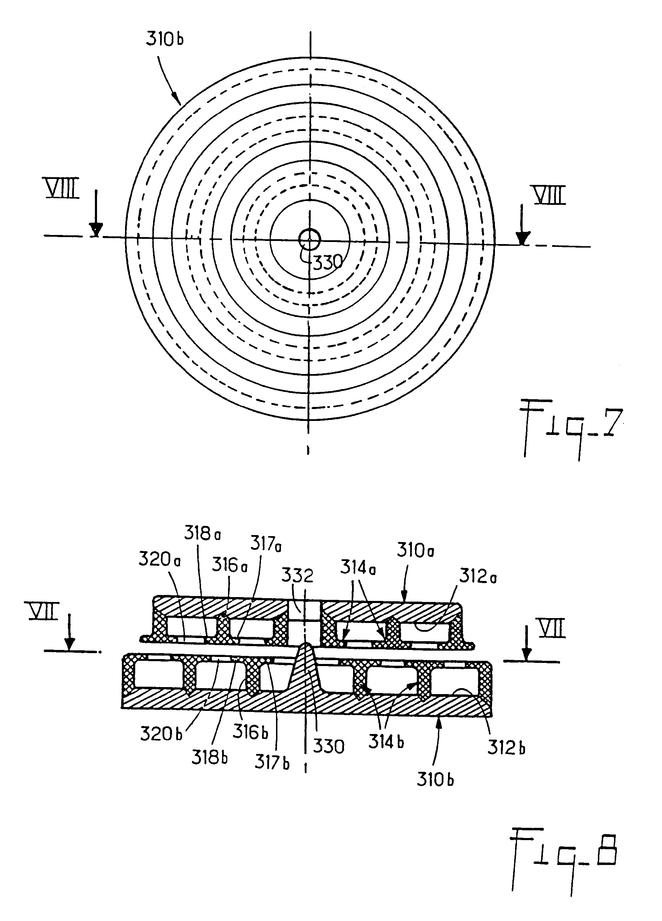

En référence aux figures 7 et 8, an a utilisé des chiffres de référence identiques à ceux utilisés à la figure 1, augmentés de 300, pour les parties identiques ou de fonction identique. Ainsi, le système d'assemblage selon l'invention est formé par deux dispositifs d'assemblage représentés par le numéro de référence général 310a, 310b. Chaque dispositif d'assemblage 310a, 310b est habituellement en forme de bande et est pourvu sur une face 312a, 312b d'une pluralité d'éléments d'accrochage 314a, 314b. Ces éléments d'accrochage 314a, 314b sont formés par des nervures 316a, 316b, pourvues de lèvres 317a, 318a ; 317b, 318b élastiquement déformables formant saillie de part et d'autre des nervures 316 pour définir entre les lèvres 317a, 318a ; 317b, 318b des étranglements 320a, 320b de dimension inférieure à l'empattement des lèvres 317a, 318a ; 317b, 318b d'une nervure donnée.

Selon la présente invention, les nervures 316a, 316b ont un profil curviligne qui est clairement visible à la figure 7.

Selon un mode de réalisation particulier tel que représenté aux figures 7 et 8, les nervures 316a, 316b ont un profil en arc de cercle. Et, selon une variante de réalisation, ces nervures 316a, 316b sont continues. De ce fait, chaque nervure 316a, 316b forme un cercle, les nervures étant disposées concentriques en ayant donc un rayon différent, comme cela est clairement visible et compréhensible à l'homme de l'art à partir des figures 7 et 8.

Il est également possible selon une autre variante de réalisation de réaliser les nervures 316a, 316b discontinues.

On observera que, selon ce mode de réalisation des figures 7 et 8, chaque dispositif d'assemblage 310a, 310b peut présenter avantageusement la forme d'un disque. Dans ce cas, pour faciliter l'assemblage, il peut être avantageux que l'un des deux dispositifs d'assemblage 310a, 310b comporte au moins un pion de centrage 330, par exemple ici réalisé au centre du disque du dispositif d'assemblage 310b venant coopérer avec un orifice traversant 332 de l'autre dispositif d'assemblage 310a, également réalisé en son centre dans le cas d'un disque. On observera par ailleurs qu'il peut être avantageux que l'un des deux dispositifs (ici le dispositif 310a) ait une dimension plus faible pour venir s'encastrer complètement dans l'autre dispositif, comme clairement visible et compréhensible à partir de la considération de la figure 8.

Pour le dispositif de dimension la plus grande, tel que 310b, figure 2, on peut prévoir que les nervures les plus externes ne comportent qu'une seule lèvre, comme représenté à la figure 8, dirigée vers l'intérieur du dispositif, et pas de lèvre dirigée vers l'extérieur, ceci d'un point de vue d'empattement total et également d'aspect esthétique.

On comprendra qu'avec ce cinquième mode de réalisation de l'invention représenté aux figures 7 et 8, on interdit tout déplacement longitudinal des dispositifs d'accrochage 310a, 310b, l'un par rapport à l'autre. Par contre, on permet un déplacement en rotation sur 360°, ce qui peut être avantageux pour certaines applications. On pourrait limiter ce déplacement en rotation à une valeur plus faible en prévoyant des butées formées par des cloisons transversales reliant les nervures si cela s'avérait nécessaire pour certaines applications particulières.

En référence aux figures 9 et 10, on a représenté un sixième mode de réalisation d'un système d'assemblage selon l'invention, en vue de dessus et coupe partielle d'un seul des deux dispositifs, les deux dispositifs étant dans ce cas de préférence de forme identique. Pour ce deuxième mode de réalisation, on a utilisé les mêmes chiffres de référence encore augmentés de 100.

Ainsi, le dispositif d'accrochage tel que 410 comprend des éléments d'accrochage 414 formés par des nervures curvilignes 416 pourvues de lèvres 417, 417 élastiquement déformables formant saillie de part et d'autre des nervures 416 pour définir entre les lèvres 417, 418 de deux nervures successives des étranglements 420 de dimension inférieure à l'empattement des lèvres 417, 418 d'une nervure 416 donnée.

Selon ce sixième mode de réalisation des figures 9 et 10, ces nervures présentent un profil sinusoïdal clairement visible à la figure 9.

On peut ainsi constater que, avec un tel système d'assemblage, on évite tout glissement longitudinal des deux dispositifs d'assemblage 410 l'un par rapport à l'autre tout en interdisant également une rotation d'un dispositif d'accrochage par rapport à l'autre, ce qui est avantageux dans certaines applications particulières.

Le procédé de fabrication d'un système d'assemblage tel que précédemment décrit en référence aux figures 7 à 10 est caractérisé en ce qu'on extrude deux bandes en matériau extrudable avec des nervures à profil curviligne.

Dans le cas particulier des figures 9 et 10, où on réalise des nervures de profil sinusoïdal, on fabrique les dispositifs d'assemblage 410 par l'emploi de deux filières d'extrusion, une filière fixe correspondant à la partie négative 440 (figure 2) et une filière mobile en aval de la filière fixe qui se déplace d'une manière alternative dans le sens perpendiculaire au défilement de la bande, pendant que le matériau extrudable est encore mou. Naturellement, la filière mobile n'agit qu'au niveau des nervures 416 et des lèvres associées 417, 418, tandis que l'embase au semelle 412 n'est évidemment pas touchée par la filière mobile. Comme matériau extrudable, on peut utiliser toute matière thermoplastique bien connue à l'homme de l'art.

On comprend que la longueur du déplacement relatif horizontal de la filière mobile par rapport à la filière fixe donnera la hauteur des sinusoïdes h, figure 9, tandis que la fréquence d'oscillation de la filière mobile par rapport à la filière fixe donnera la longueur d'une sinusoïde ou période l. On comprend immédiatement que le dispositif d'assemblage du type du dispositif 410 s'assemble d'une manière extrêmement simple tout en interdisant tout déplacement dans le sens longitudinal même lorsque l'on tire fortement et d'une manière inverse sur les deux dispositifs d'assemblage en position assemblée par accrochage. On obtient ainsi tous les avantages techniques déterminants précédemment énoncés.

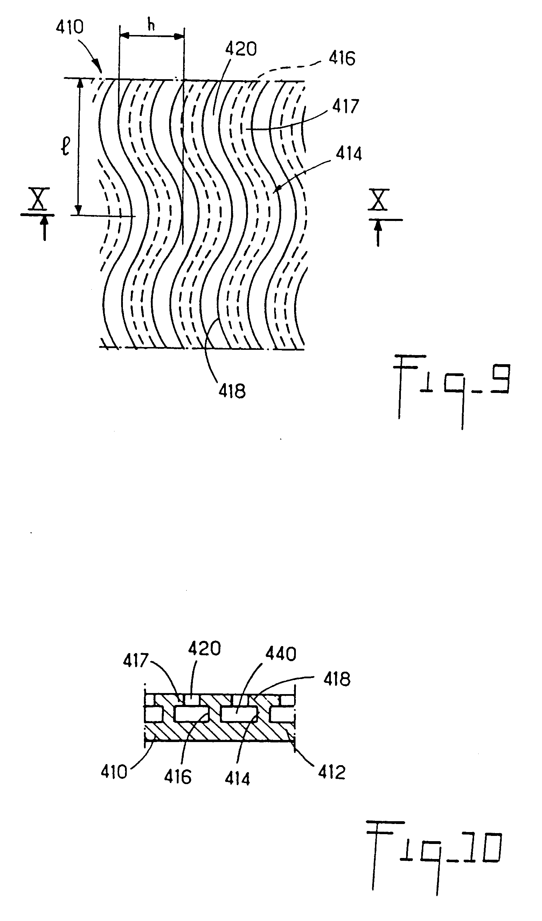

En référence aux figures 11 et 12, on a représenté encore un autre mode de réalisation d'un système d'assemblage selon l'invention, pour lequel les chiffres de référence ont encore été augmentés de 100 par rapport au mode de réalisation précédent, selon lequel les lèvres 517a, 518a ; 517b, 518b du premier dispositif d'assemblage 510a et du second dispositif d'assemblage 510b, respectivement comprennent à leur extrémité un bec recourbé, respectivement 530a, 532a et 530b, 532b. Ce bec recourbé peut être remplacé par une surépaisseur interne à l'extrémité des lèvres. Le bec recourbé ou la surépaisseur interne servent de point de résistance contre un désassemblage comme cela est bien compréhensible à partir de la position assemblée représentée à la figure 12.

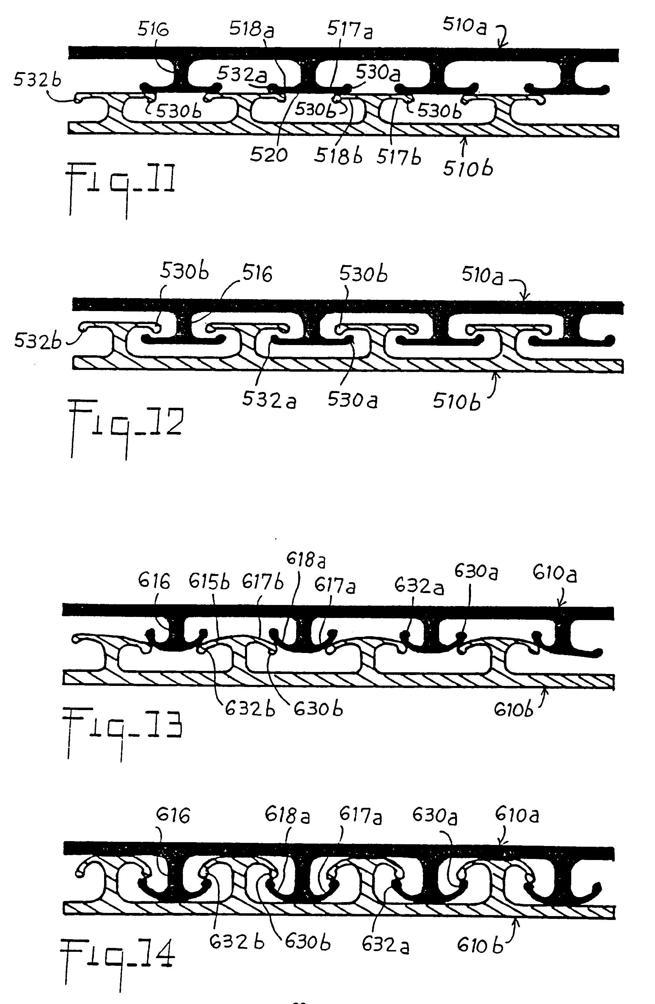

De même, selon encore la variante de réalisation représentée aux figures 13 et 14, pour laquelle les chiffres de référence ont encore été augmentés de 100, on observe que les lèvres 617a, 618a ; 617b, 618b comportent une surépaisseur 630a, 632a ; 630b, 632b interne, ou encore un bec recourbé vers la nervure, servant de point de résistance contre un désassemblage.

On observera encore que dans la variante de réalisation des figures 13 et 14, le profil général des lèvres d'une nervure donnée est incurvé en direction de la nervure, l'ensemble lèvres-nervures ayant ainsi approximativement une forme en champignon.

Dans tous les modes de réalisation précédents, il est préféré selon l'invention que le rapport en pourcentage de l'épaisseur des lèvres à l'épaisseur des nervures soit compris entre 20-30 et 70-80, de préférence entre 20-30 et 60-70.

On comprend ainsi que l'on obtient tous les avantages techniques déterminants, inattendus, et non évidents pour un homme du métier, précédemment énoncés.

Les applications du système d'assemblage selon l'invention sont nombreuses et peuvent être définies principalement comme suit :

A) - Pour les applications courantes :

On peut réaliser le système d'assemblage pour une fabrication du type "extrudé" en matière plastique ou thermoplastique par formage à chaud, avec un prix de revient extrêmement faible et une précision moyenne.

Les applications essentielles sont : la couture, les accrochages classiques type "Velcro", la fixation de doublures, la papeterie, la décoration bon marché, etc...

Un exemple précis de réalisation est le suivant : on utilise comme matériau un élastomère, tel que le néoprène. Les dispositifs d'accrochage 10 sont réalisés en néoprène par formage à chaud.

La dimension des nervures 16 est de 0,5 mm d'épaisseur pour une hauteur de 3 mm, tandis que les lèvres 17, 18 ont une épaisseur de 0,30 mm et une largeur de 1,50 mm.

Le profil est en "T" droit, l'ensemble des lèvres et des nervures étant ainsi inclus dans un triangle équilatéral de 3 mm de côté.

Ces éléments d'accrochage 14, par les nervures 15 et les lèvres 17, 18, forment corps avec une bande 16 formant semelle d'épaisseur 0,5 mm.

La dimension totale du dispositif d'assemblage peut représenter une surface totale de 1 à 3 cm$^2$ par exemple pour remplacer facilement un bouton.

On peut équiper par exemple un couvercle type couvercle de poubelle ou de récipient par solidarisation d'une bande circonférentielle constituée par ce dispositif d'accrochage 10.

B) Applications assez sophistiquées

Il s'agit par exemple de l'ameublement, la tapisserie, la décoration, les stands, les intérieurs d'automobiles, etc...

Une application particulièrement intéressante est la décoration des plafonds, car avec le système d'accrochage selon l'invention comportant deux dispositifs d'assemblage 10 identiques, il n'y a pas de vieillissement thermique ni dynamique, donc aucun décollement et, des applications soumises à la gravité se comportent très bien avec le système d'assemblage selon l'invention, qui présente une résistance à l'arrachement ou au désassemblage très élevée, pouvant être tirée très largement en fonction de la nature du matériau utilisé pour réaliser les nervures et les lèvres.

C) Applications de haute technologie

On peut citer toutes les applications scientifiques : dans les laboratoires, l'aéronautique, le spatial, les isolations électriques, phoniques et thermiques, etc.

A titre d'exemple, on peut citer une utilisation remarquable du système d'accrochage selon l'invention pour réaliser l'intérieur des aéronefs, qui peut être fait en cloisons anti-feu avec des matériaux composites eux-mêmes anti-feu et fixé par accrochage conformément au système d'assemblage par accrochage selon l'invention en évitant ainsi l'utilisation de colles, lesquelles sont souvent l'objet de fumées toxiques en cas d'incendie.

L'invention peut être utilisée dans les travaux publics pour réaliser notamment des systèmes d'assemblage avec des antennes, des grues...

Il est à noter que le mode de réalisation des figures 7 et 8 est particulièrement intéressant lorsqu'on désire un accrochage autorisant une grande liberté de mouvement sur 360°, comme c'est le cas dans les accrochages de sous-vêtements, de couches-culottes, etc., afin de ne pas entraver le déplacement des jambes par un verrouillage fixe. L'invention permet de réaliser un déplacement alternatif ou continu en rotation des dispositifs d'assemblage l'un par rapport à l'autre en position assemblée par accrochage. On peut citer d'autres exemples sur le plan industriel où l'on demande un mouvement de liberté en rotation en même temps qu'une attache sérieuse, tels que : bâches amovibles, cerclages d'objets mobiles, etc.

**Revendications**

1. Système d'assemblage par accrochage, notamment pour fermetures par accrochage, comprenant un premier dispositif d'assemblage habituellement en forme de bande, pourvu sur une face dite d'accrochage d'une pluralité de premiers éléments d'accrochage au moins en partie élastiquement déformables et un deuxième dispositif d'assemblage également habituellement en forme de bande, pourvu sur une face dite d'accrochage d'une pluralité de seconds éléments d'accrochage au moins en partie élastiquement déformables, permettant, lors d'un rapprochement relatif desdits premier et second dispositifs d'accrochage avec leurs éléments d'accrochage en regard les uns des autres, l'accrochage des seconds éléments d'accrochage avec les premiers éléments d'accrochage par déformation élastique des premiers éléments d'accrochage et des seconds éléments d'accrochage, caractérisé en ce que les éléments d'accrochage (14) sont formés par des nervures (16) pourvues de lèvres (17, 18) élastiquement déformables formant saillie de part et d'autre des nervures (16) pour définir entre les lèvres (16, 17) de deux nervures successives des étranglements (20) de dimension inférieure à l'empattement des lèvres (17, 18) d'une nervure (16) donnée.

2. Système d'assemblage selon la revendication 1, caractérisé en ce que les nervures (16) sont discontinues.

3. Système d'assemblage selon la revendication 2, caractérisé en ce que les nervures (16) sont alignées et sont séparées par des saignées (22) dont la dimension est inférieure à la longueur des nervures (16).

4. Système d'assemblage selon la revendication 2, caractérisé en ce que les nervures (214a, 214b) sont décalées, de préférence d'un demi-pas, ou en quinconce.

5. Système d'assemblage selon l'une quelconque des revendications 1 à 4, caractérisé en ce que les nervures avec leurs lèvres ont, en section droite, un profil en T, les lèvres (17, 18) formant avec les nervures (16) un angle au plus égal à 90° environ.

6. Système d'assemblage selon l'une des revendications 1 à 5, caractérisé en ce que les nervures avec leurs lèvres sont réalisées en un matériau choisi parmi le groupe consistant d'un métal, d'une matière plastique, ou d'un matériau composite.

7. Système d'assemblage par accrochage, notamment pour fermetures par accrochage, comprenant un premier dispositif d'assemblage habituellement en forme de bande, pourvu sur une face dite d'accrochage d'une pluralité de premiers éléments d'accrochage au moins en partie élastiquement déformables et un deuxième dispositif d'assemblage également habituellement en forme de bande, pourvu sur une face dite d'accrochage d'une pluralité de seconds éléments d'accrochage au moins en partie élastiquement déformables, permettant, lors d'un rapprochement relatif desdits premier et second dispositifs d'accrochage avec leurs éléments d'accrochage en regard les uns des autres, l'accrochage des seconds éléments d'accrochage avec les premiers éléments d'accrochage par déformation élastique des premiers éléments d'accrochage et des seconds éléments d'accrochage, caractérisé en ce que les éléments d'accrochage sont formés par des nervures pourvues de lèvres élastiquement déformables formant saillie de part et d'autre des nervures pour définir entre les lèvres de deux nervures successives des étranglements de dimension inférieure à l'empattement des lèvres d'une nervure donnée, et en ce que lesdites nervures (316, 416) ont un profil curviligne.

8. Système d'assemblage selon la revendication 7, caractérisé en ce que les nervures précitées (316a, 316b) ont un profil en arc de cercle, avantageusement sont concentriques.

9. Système d'assemblage selon la revendication 7 ou 8, caractérisé en ce que les nervures (416) ont un profil sinusoïdal.

10. Système d'assemblage selon l'une des revendications 7 à 9, caractérisé en ce que les nervures (316, 416) sont discontinues.

11. Système d'assemblage selon la revendication 10, caractérisé en ce que les nervures sont alignées et sont séparées par des saignées dont la dimension est inférieure à la longueur des nervures.

12. Système d'assemblage selon l'une quelconque des revendications 7 à 11, caractérisé en ce que les nervures (316, 416) avec leurs lèvres ont, en section droite, un profil en T, les lèvres (317, 318 ; 417, 418) formant avec les nervures (316, 416) un angle au plus égal à 90° environ.

13. Système d'assemblage selon l'une quelconque des revendications 7 à 12, caractérisé en ce que les nervures avec leurs lèvres sont réalisées en un matériau choisi parmi le groupe consistant d'un métal, d'une matière plastique, ou d'un matériau composite.

14. Système d'assemblage selon l'une quelconque des revendications 1 à 13, caractérisé en ce que le rapport en pourcentage de l'épaisseur des lèvres à l'épaisseur des nervures est compris entre 20-30 et 70-80, de préférence entre 20-30 et 60-70.

15. Système d'assemblage selon l'une quelconque des revendications 1 à 14, caractérisé en ce que le profil général des lèvres d'une nervure donnée est incurvé en direction de la nervure (figure 2 ; figures 13 et 14).

16. Système d'assemblage selon l'une quelconque des revendications 1 à 15, caractérisé en ce que l'extrémité des lèvres (517a, 518a 517b, 518b ; 617a, 618a, 617b, 618b) comprend un bec recourbé (530a, 532a ; 530b, 532b) vers la nervure (516) ou une surépaisseur (630a, 632a ; 630b, 632b) interne, servant de point de résistance contre un désassemblage.

17. Procédé de fabrication d'un dispositif d'assemblage (10, 100) pour système d'assemblage, caractérisé en ce qu'on réalise des plis (30, 40) sensiblement parallèles dans deux bandes (32, 42) à l'aide de tout moyen de plissage approprié, on dispose ces deux bandes (32, 42) à une distance prédéterminée l'une de l'autre avec les plis respectifs en regard mais décalés, on rapproche les deux bandes (32, 42) jusqu'à ce que les bords des plis (30, 40) d'une bande soient en contact avec l'autre bande ; on solidarise les bords des plis (30, 40) avec la bande avec laquelle ils sont en contact ; et on réalise des découpes (50) entre les plis (30, 40) sur une seule (32) des deux bandes (32, 42).

18. Procédé selon la revendication 17, caractérisé en ce qu'on solidarise une autre bande formant support (S) sur la bande (42) opposée à celle (32) comportant les découpes ou destinée à comporter les découpes (50), par exemple un tissé.

19. Procédé selon la revendication 17 ou la revendication 18, caractérisé en ce que les plis précités (30, 40) comprennent des tronçons successifs dont au moins certains sont décalés d'un demi-pas.

20. Procédé selon l'une des revendications 17 à 19, caractérisé en ce que les bandes précitées (32, 42) sont des bandes continues, le procédé étant ainsi réalisé en continu par déroulage continu de chaque bande (32, 42) qui peut être ensuite découpée à la longueur voulue.

21. Procédé de fabrication d'un dispositif d'assemblage (310, 410) pour système d'assemblage selon la revendication 9, caractérisé en ce qu'on extrude deux bandes en matériau extrudable avec des nervures(416) à profil sinusoïdal par l'emploi de deux filières, une filière fixe et une filière mobile se déplaçant alternativement dans le sens perpendiculaire au défilement de la bande pendant que le matériau extrudable est encore mou.

**Patentansprüche**

1. Verhakungsverbindungssystem, insbesondere für Verhakungsverschlüsse, umfassend eine erste Verbindungseinrichtung, üblicherweise in Bandform, die auf einer sogenannten Verhakungsseite mit einer Mehrzahl von ersten, zumindest teilweise elastisch verformbaren Verhakungselementen versehen ist, und eine zweite Verbindungseinrichtung, ebenfalls üblicherweise in Bandform, die auf einer sogenannten Verhakungsseite mit einer Mehrzahl von zweiten, zumindest teilweise elastisch verformbaren Verhakungselementen versehen ist, die bei einer relativen Annäherung der ersten und zweiten Verhakungseinrichtung mit ihren Verhakungselementen in Gegenüberstellung die Verhakung der zweiten Verhakungselemente mit den ersten Verhakungselementen durch elastische Verformung der ersten Verhakungselemente und der zweiten Verhakungselemente gestatten, dadurch gekennzeichnet, daß die Verhakungselemente (14) durch Rippen (16) gebildet sind, die mit elastisch verformbaren Lippen (17, 18) versehen sind, welche beiderseits der Rippen (16) abstehen, um zwischen den Lippen (17, 18) zweier aufeinanderfolgender Rippen Verengungen (20) von einer Abmessung geringer als die Spannweite der Lippen (17, 18) einer gegebenen Rippe (16) zu definieren.

2. Verbindungssystem nach Anspruch 1, dadurch gekennzeichnet, daß die Rippen (16) unterbrochen sind.

3. Verbindungssystem nach Anspruch 2, dadurch gekennzeichnet, daß die Rippen (16) fluchten und durch Schlitze (22) voneinander getrennt sind, deren Abmessung geringer als die Länge der Rippen (16) ist.

4. Verbindungssystem nach Anspruch 2, dadurch gekennzeichnet, daß die Rippen (214a, 214b) versetzt, vorzugsweise um einen Halbschritt, oder wechselweise versetzt angeordnet sind.

5. Verbindungssystem nach einem der Ansprüche 1 bis 4, dadurch gekennzeichnet, daß die Rippen mit ihren Lippen im Querschnitt ein T-Profil haben, wobei die Lippen (17, 18) mit den Rippen (16) einen Winkel von höchstens etwa 90° einschließen.

6. Verbindungssystem nach einem der Ansprüche 1 bis 5, dadurch gekennzeichnet, daß die Rippen mit ihren Lippen aus einem Material, ausgewählt aus der Gruppe bestehend aus einem Metall, einem Kunststoff oder einem Verbundwerkstoff, hergestellt sind.

7. Verhakungsverbindungssystem, insbesondere für Verhakungsverschlüsse, umfassend eine erste Verbindungseinrichtung, üblicherweise in Bandform, die auf einer sogenannten Verhakungsseite mit einer Mehrzahl von ersten, zumindest teilweise elastisch verformbaren Verhakungselementen versehen ist, und eine zweite Verbindungseinrichtung, ebenfalls üblicherweise in Bandform, die auf einer sogenannten Verhakungsseite mit einer Mehrzahl von zweiten, zumindest teilweise elastisch verformbaren Verhakungselementen versehen ist, die bei einer relativen Annäherung der ersten und zweiten Verhakungseinrichtung mit ihren Verhakungselementen in Gegenüberstellung die Verhakung der zweiten Verhakungselemente mit den ersten Verhakungselementen durch elastische Verformung der ersten Verhakungselemente und der zweiten Verhakungselemente gestatten, dadurch gekennzeichnet, daß die Verhakungselemente durch Rippen gebildet sind, die mit elastisch verformbaren Lippen versehen sind, welche beiderseits der Rippen abstehen, um zwischen den Lippen zweier aufeinanderfolgender Rippen Verengungen von einer Abmessung geringer als die Spannweite der Lippen einer gegebenen Rippe zu definieren, und daß die Rippen (316, 416) eine gekrümmte Form haben.

8. Verbindungssystem nach Anspruch 7, dadurch gekennzeichnet, daß die Rippen (316a, 316b) eine kreisbogenförmige Form haben, vorteilhafterweise konzentrisch sind.

9. Verbindungssystem nach Anspruch 7 oder 8, dadurch gekennzeichnet, daß die Rippen (416) eine sinusförmige Form haben.

10. Verbindungssystem nach einem der Ansprüche 7 bis 9, dadurch gekennzeichnet, daß die Rippen (316, 416) unterbrochen sind.

11. Verbindungssystem nach Anspruch 10, dadurch gekennzeichnet, daß die Rippen fluchten und durch Schlitze getrennt sind, deren Abmessung geringer als die Länge der Rippen ist.

12. Verbindungssystem nach einem der Ansprüche 7 bis 11, dadurch gekennzeichnet, daß die Rippen (316, 416) mit ihren Lippen im Querschnitt ein T-Profil haben, wobei die Lippen (317, 318; 417, 418) mit den Rippen (316, 416) einen Winkel von höchstens etwa 90° einschließen.

13. Verbindungssystem nach einem der Ansprüche 7 bis 12, dadurch gekennzeichnet, daß die Rippen mit ihren Lippen aus einem Material, ausgewählt aus der Gruppe bestehend aus einem Metall, einem Kunststoff oder einem Verbundwerkstoff, hergestellt sind.

14. Verbindungssystem nach einem der Ansprüche 1 bis 13, dadurch gekennzeichnet, daß das prozentmäßige Verhältnis der Dicke der Lippen zur Dicke der Rippen zwischen 20-30 und 70-80, vorzugswesie zwischen 20-30 und 60-70, liegt.

15. Verbindungssystem nach einem der Ansprüche 1 bis 14, dadurch gekennzeichnet, daß das allgemeine Profil der Lippen einer gegebenen Rippe in Richtung der Rippe gekrümmt ist (Fig. 2; Fig. 13 und 14).

16. Verbindungssystem nach einem der Ansprüche 1 bis 15, dadurch gekennzeichnet, daß das Ende der Lippen (517a, 518a, 517b, 518b; 617a, 618a, 617b, 618b) einen zur Rippe (516) zurückgebogenen Ansatz (530a, 532a; 530b, 532b) oder eine innere Überdicke (630a, 632a; 630b, 632b) aufweist, die als Widerstandspunkt gegen ein Lösen dienen.

17. Verfahren zur Herstellung einer Verbindungseinrichtung (10, 100) für ein Verbindungssystem, dadurch gekennzeichnet, daß in zwei Bändern (32, 42) mit Hilfe irgendeines geeigneten Faltwerkzeugs im wesentlichen parallele Falten (30, 40) eingearbeitet werden, diese beiden Bänder (32, 42) mit den jeweiligen Falten zueinanderschauend, aber versetzt, in einem bestimmten Abstand voneinander angeordnet werden, die beiden Bänder (32, 42) einander genähert werden, bis sich die Ränder der Falten (30, 40) eines Bandes in Kontakt mit dem anderen Band befinden, die Ränder der Falten (30, 40) mit dem Band, mit dem sie in Kontakt sind, fest verbunden werden, und nur in einem (32) der beiden Bänder (32, 42) zwischen den Falten (30, 40) Einschnitte (50) vorgenommen werden.

18. Verfahren nach Anspruch 17, dadurch gekennzeichnet, daß ein anderes, einen Träger (S) bildendes Band am Band (42), das jenem (32) gegenüberliegt, das die Einschnitte aufweist oder mit den Einschnitten (50) zu versehen ist, befestigt wird, beispielsweise ein Gewebe.

19. Verfahren nach Anspruch 17 oder 18, dadurch gekennzeichnet, daß die Falten (30, 40) aufeinanderfolgende Abschnitte aufweisen, von denen zumindest gewisse um einen Halbschritt versetzt sind.

20. Verfahren nach einem der Ansprüche 17 bis 19, dadurch gekennzeichnet, daß die Bänder (32, 42) Endlosbänder sind, wobei das Verfahren kontinuierlich durch kontinuierliches Abspulen jedes Bandes (32, 42), das danach in die gewünschte Länge geschnitten werden kann, durchgeführt wird.

21. Verfahren zur Herstellung einer Verbindungseinrichtung (310, 410) für ein Verbindungssystem nach Anspruch 9, dadurch gekennzeichnet, daß zwei Bänder aus exdrudierbarem Material mit Rippen (416) von sinusförmigem Profil durch den Einsatz von zwei Ziehdüsen extrudiert werden, u.zw. einer feststehenden Ziehdüse und einer beweglichen Ziehdüse, die sich abwechselnd in zur Ablaufrichtung des Bandes senkrechter Richtung bewegt, während das extrudierbare Material noch weich ist.

## Claims

1. System for joining by interengagement, particularly for fasteners by interengagement, comprising a first joining device conventionally in the form of a tape, provided on a so-called interengagement face with a plurality of first interengaging elements which are at least partly elastically deformable, and a second joining device likewise conventionally in the form of a tape, provided on a so-called interengagement face with a plurality of second interengaging elements which are at least partly elastically deformable, allowing, upon a relative approach of said first and second joining devices with their interengaging elements opposite one another, the interengagement of the second interengaging elements with the first interengaging elements by elastic deformation of the first and second interengaging elements, characterized in that the interengaging elements (14) are formed by ridges (16) provided with elastically deformable lips (17, 18) projecting on either side of the ridges (16) to define between the lips (16, 17) of two successive ridges contractions (20) narrower than the projection of the lips (17, 18) of a given ridge (16).

2. Joining system according to claim 1, characterized in that the ridges (16) are discontinuous.

3. Joining system according to claim 2, characterized in that the ridges (16) are aligned and are separated by notches (22) whose dimension is smaller than the length of the ridges (16).

4. Joining system according to claim 2, characterized in that the ridges (214a, 214b) are offset, preferably by a half-pitch, or in quincunx.

5. Joining system according to any one of claims 1 to 4, characterized in that the ridges with their lips are T-shaped in cross section, the lips (17, 18) forming with the ridges (16) an angle at the most equal to about 90°.

6. Joining system according to one of claims 1 to 5, characterized in that the ridges with their lips are made of a material selected from the group consisting of a metal, a plastics material, or a composite material.

7. Joining system by interengagement, particularly for fasteners by interengagement, comprising a first joining device conventionally in the form of a tape, provided on a so-called interengagement face with a plurality of first interengaging elements which are at least partly elastically deformable, and a second joining device likewise conventionally in the form of a tape, provided on a so-called interengagement face with a plurality of second interengaging elements which are at least partly elastically deformable, allowing, upon a relative approach of said first and second joining devices with their interengaging elements opposite one another, the interengagement of the second interengaging elements with the first interengaging elements by elastic deformation of the first and second interengaging elements, characterized in that the interengaging elements are formed by ridges provided with elastically deformable lips projecting on either side of the ridges to define between the lips of two successive ridges contractions narrower than the projection of the lips of a given ridge, and in that said ridges (316, 416) have a curvilinear section.

8. Joining system according to claim 7, characterized in that the said ridges (316a, 316b) have an arcuate section, are advantageously concentric.

9. Joining system according to claim 7 or 8, characterized in that the ridges (416) have a sinusoidal section.

10. Joining system according to one of claims 7 to 9, characterized in that the ridges (316, 416) are discontinuous.

11. Joining system according to claim 10, characterized in that the ridges are aligned and are separated by notches whose dimension is smaller than the length of the ridges.

12. Joining system according to any one of claims 7 to 11, characterized in that the ridges (316, 416) with their lips have a T-shaped cross section, the lips (317, 318; 417, 418) forming with the ridges (316, 416) an angle at the most equal to about 90°.

13. Joining system according to any one of claims 7 to 12, characterized in that the ridges with their lips are made of a material selected from the group consisting of a metal, a plastics material or a composite material.

14. Joining system according to any one of claims 1 to 13, characterized in that the ratio in percentage of the thickness of the lips to the thickness of the ridges is included between 20-30 and 70-80, preferably between 20-30 and 60-70.

15. Joining system according to any one of claims 1 to 14, characterized in that the general section of the lips of a given ridge is curved in the direction of the ridge (Figure 2; Figures 13 and 14).

16. Joining system according to any one of claims 1 to 15, characterized in that the end of the lips (517a, 518a, 517 b, 518b; 617a, 618a, 617b, 618b) comprises a nose (530a, 532a; 530b, 532b) curved towards the ridge (516) or an inner excess thickness (630a, 632a; 630b, 632b) serving as point of resistance against disassembly.

17. Process for manufacturing a joining device (10, 100) for joining system, characterized in that substantially parallel folds (30, 40) are made in two tapes (32, 42) with the aid of any appropriate folding means, these two tapes (32, 42) are disposed at a predetermined distance from each other with the respective folds opposite but offset, the two tapes (32, 42) are approached until the edges of the folds (30, 40) of one tape are in contact with the other tape; the edges of the folds (30, 40) are connected with the tape with which they are in contact; and cut-outs (50) are made between the folds (30, 40) on only one (32) of the two tapes (32, 42).

18. Process according to claim 17, characterized in that another tape forming support (S) is connected on the tape (42) opposite the one (32) comprising the cut-outs or intended to comprise the cut-outs (50), for example a weave.

19. Process according to claim 17 or claim 18, characterized in that the said folds (30, 40) comprise successive sections of which at least certain are offset by a half-pitch.

20. Process according to one of claims 17 to 19, characterized in that the said tapes (32, 42) are continuous tapes, the process thus being carried out continuously by continuously unrolling each tape (32, 42) which may then be cut to the desired length.

21. Process for manufacturing a joining device (310, 410) for joining system according to claim 9, characterized in that two tapes of extrudable material with ridges (416) with sinusoidal section are extruded by using two dies, a fixed die and a mobile die moving in reciprocating manner in the direction perpendicular to the advance of the tape whilst the extrudable material is still soft.

Fig-1

Fig-2

Fig-3

Fig. 4a

Fig. 4b

Fig. 4c

Fig. 4d

16

Fig_5a

Fig_5b

Fig_5c

Fig_5d

Fig_6

Fig.7

Fig.8

Fig_9

Fig_10

516  518a  517a  510a

532b  532a  530a

530b  530b  530b

520  518b  517b  510b

Fig_11

530b  516  530b  510a

532b

532a  530a  510b

Fig_12

616  615b  617b  618a  617a  632a  630a  610a

632b  630b  610b

Fig_13

616  618a  617a  630a  610a

632b  630b  632a  610b

Fig_14